# EUROPEAN PATENT APPLICATION

(11) **EP 4 841 277 A1**
(43) Date of publication of application: **18.11.2026**
(21) Application number: 26169031.7
(22) Date of filing: 30.03.2026
(51) Int. Cl.: G01R 31/367, G01R 31/392

(54) **MACHINE LEARNING METHOD, MACHINE LEARNING DEVICE, AND TRAINED MODEL**

(30) Priority: 13.05.2025 JP 2025080446
(71) Applicant: Toyota Jidosha Kabushiki Kaisha, Toyota-shi, Aichi-ken 471-8571 (JP)
(72) Inventor: YOKOYAMA, Daiki, Toyota-shi, 471-8571 (JP); YOKOYAMA, Kouichi, Toyota-shi, 471-8571 (JP)
(74) Representative: J A Kemp LLP

(57) **Abstract**

A machine learning performed by a computer includes first to third steps. The first step is a step of acquiring first learning data indicating a use history of a battery (51) during primary use of the battery, and having been used for training a first learning model (124) configured to estimate, during the primary use, a battery parameter indicating a state of the battery (51). The second step is a step of generating second learning data indicating a use history of the battery (52) during secondary use of the battery. The third step is a step of training a second learning model (225) by inputting the first learning data and the second learning data to the second learning model (225) for estimating the battery parameter during the secondary use.

## Description

### CROSS REFERENCE TO RELATED APPLICATIONS

This nonprovisional application is based on Japanese Patent Application No. 2025-080446 filed on May 13, 2025 with the Japan Patent Office, the entire contents of which are hereby incorporated by reference.

### BACKGROUND

### Field

The present disclosure relates to a machine learning method, a machine learning device, and a trained model.

### Description of the Background Art

In recent years, in order to reduce the environmental load, reuse of a battery mounted on a vehicle or the like has been required. Various techniques related to battery reuse have been proposed. A method of estimating a state of charge of a power storage device disclosed in WO2019/193471 includes: determining an electrical circuit model of the power storage device; optimizing the electrical circuit model of the power storage device such that an input is a current and an output is a voltage, and an output error of a voltage of the power storage device is reduced; calculating an initial parameter of the electrical circuit model of the power storage device; storing an initial parameter group corresponding to different input current values; determining an initial parameter value by neural network processing using the initial parameter group as training data; and estimating the charging rate by calculating the initial parameter by Kalman filter processing.

### SUMMARY

It has been proposed to use a trained model generated by machine learning, in order to estimate a battery parameter (a parameter indicating a state of charge, a state of health, or the like) indicating a state of a battery during primary use of the battery.

For secondary use, i.e., reuse of the battery after primary use of the battery, the trained model may also be used in a similar manner to that during the primary use of the battery. However, study has hardly been conducted on how to train a machine learning model for secondary use of the battery. It is desirable to be able to suitably provide a machine learning model (trained model) to be used for secondary use of a battery.

The present disclosure is made to solve the above-described problem, and one of objects of the present disclosure is to suitably generate a trained model to be used for secondary use of a battery.

A machine learning method according to a first aspect of the present disclosure is a machine learning method performed by a computer and including first to third steps. The first step is a step of acquiring first learning data indicating a use history of a battery during primary use of the battery, and having been used for training a first learning model configured to estimate, during the primary use, a battery parameter indicating a state of the battery. The second step is a step of generating second learning data indicating a use history of the battery during secondary use of the battery. The third step is a step of training a second learning model by inputting the first learning data and the second learning data to the second learning model for estimating the battery parameter during the secondary use.

A machine learning device according to a second aspect of the present disclosure includes a first data acquisition unit, a second data acquisition unit, and a learning unit. The first data acquisition unit acquires first learning data indicating a use history of a battery during primary use of the battery, and having been used for training a first learning model configured to estimate, during the primary use, a battery parameter indicating a state of the battery. The second data acquisition unit acquires second learning data indicating a use history of the battery during secondary use of the battery. The learning unit trains a second learning model by inputting the first learning data and the second learning data to the second learning model for estimating the battery parameter during the secondary use.

A trained model according to a third aspect of the present disclosure is a trained model that causes a computer to perform a process of outputting a result of estimation of a battery parameter indicating a state of a battery during secondary use of the battery, in response to receiving input data indicating a use history of the battery during secondary use of the battery. The trained model includes a model architecture. The model architecture is trained based on first learning data and second learning data, the first learning data indicating a use history of the battery during primary use of the battery, and having been used for training a first learning model configured to estimate the battery parameter during the primary use, and the second learning data indicating the use history during the secondary use.

According to the method or the configuration described above, the first learning data having been used for training the first learning model during primary use of the battery is also used for training the second learning model to be used during secondary use of the battery. Accordingly, even in the case where or at the time when learning data (second learning data) necessary for training the second learning model cannot be prepared during secondary use of the battery, a sufficient amount of learning data (first learning data and second learning data) can be ensured. Thus, the second trained model to be used during the secondary use of the battery can be generated suitably.

The foregoing and other objects, features, aspects and advantages of the present disclosure will become more apparent from the following detailed description of the present disclosure when taken in conjunction with the accompanying drawings.

### BRIEF DESCRIPTION OF THE DRAWINGS

Fig. 1 is a block diagram illustrating an example of an overall configuration of a battery management system according to an embodiment of the present disclosure.
Fig. 2 is a block diagram illustrating an example of a configuration of a first server and a vehicle ECU each relating to primary use of a battery.
Fig. 3 is a block diagram illustrating an example of a configuration of a second server and a device controller each relating to secondary use of a battery.
Fig. 4 is a conceptual diagram for explaining a machine learning model according to an embodiment of the present disclosure.
Fig. 5 is a diagram for explaining generation of a first learning model relating to primary use of a battery.
Fig. 6 is a diagram for explaining generation of a second learning model relating to secondary use of a battery.
Fig. 7 is a diagram for explaining first learning data used for training a second learning model.
Fig. 8 is a flowchart illustrating an example of a processing procedure related to generation of first learning data and generation of a first trained model during primary use of a battery.
Fig. 9 is a flowchart illustrating an example of a processing procedure related to acquisition of first learning data during secondary use of a battery.
Fig. 10 is a flowchart illustrating an example of a processing procedure related to generation of a second trained model during secondary use of a battery.
Fig. 11 is a flowchart illustrating an example of a processing procedure for inference by the first trained model or the second trained model.

### DESCRIPTION OF THE PREFERRED EMBODIMENTS

Hereinafter, embodiments of the present disclosure will be described in detail with reference to the drawings. In the drawings, the same or corresponding parts are denoted by the same reference characters, and the description thereof will not be repeated.

### [Embodiments]

### <Overall System Configuration>

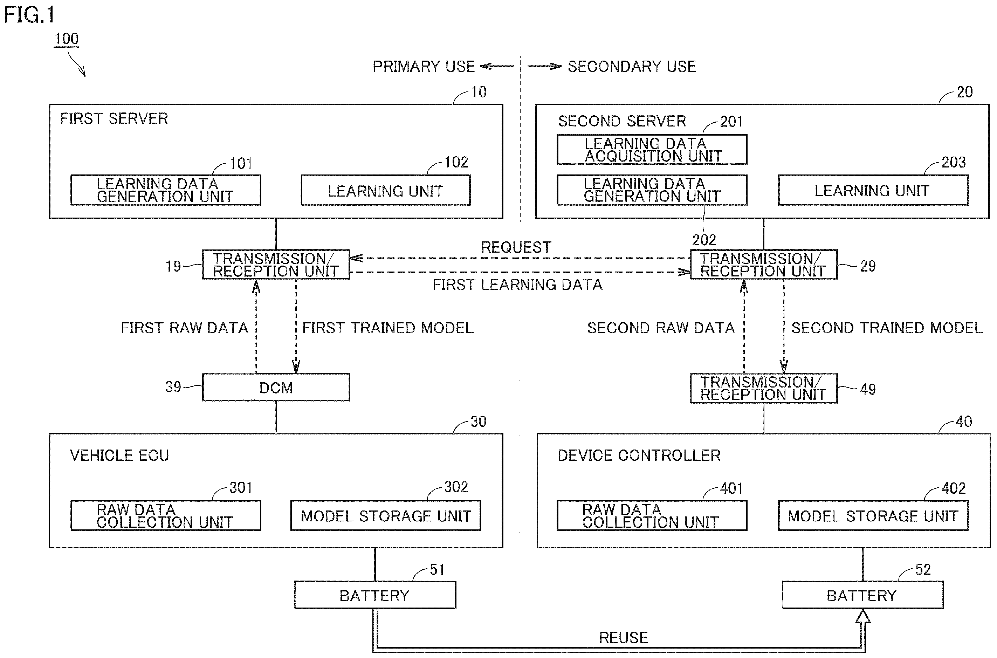

Fig. 1 is a block diagram illustrating an example of an overall configuration of a battery management system according to an embodiment of the present disclosure. The battery management system 100 includes a first server 10, a second server 20, a vehicle ECU (Electronic Control Unit) 30, and a device controller 40.

In the present embodiment, as one exemplary embodiment, it is assumed that a battery is used for a vehicle in primary use, while the battery is used for a stationary use in secondary use. That is, a battery 51 mounted on a vehicle is reused as a battery 52 of a stationary power supply system. However, the applications of the batteries 51 and 52 are not particularly limited. The applications may be opposite to those in this example. Alternatively, both primary use and secondary use applications may be those for the vehicle, or both primary use and secondary use applications may be those for the stationary use.

Each of the batteries 51 and 52 is a battery assembly including a plurality of secondary batteries. The types of the batteries 51 and 52 are not particularly limited. The batteries 51 and 52 may be, for example, lithium ion batteries, nickel-metal hydride batteries, or all-solid-state batteries.

The first server 10 is a server for managing primary use of the battery 51. The first server 10 is managed and operated by, for example, a manufacturer of the vehicle. The first server 10 includes a learning data generation unit 101 and a learning unit 102. The learning data generation unit 101 generates first learning data used for learning of the first learning model based on first raw data (such as data measured by various sensors installed in the vehicle) collected from the vehicle (preferably, a large number of vehicles equipped with batteries of the same type). The learning unit 102 generates a first trained model by performing machine learning on the first learning model using the first learning data.

The first server 10 is connected to a transmission/reception unit 19 that transmits and receives information to and from external devices (such as the second server 20 and the vehicle ECU 30). The first server 10 transmits the first learning data to the second server 20 in accordance with a request from the second server 20. The first server 10 acquires raw data from the vehicle ECU 30 (preferably, ECUs of a large number of vehicles equipped with batteries of the same type). In addition, the first server 10 provides the first trained model to the vehicle ECU 30.

The second server 20 is a server for managing secondary use of the battery 52. For example, the second server 20 may be managed and operated by a manufacturer of the vehicle or may be managed and operated by an administrator of the stationary power supply system. The second server 20 includes a learning data acquisition unit 201, a learning data generation unit 202, and a learning unit 203. The learning data acquisition unit 201 acquires the first learning data from the first server 10. The learning data generation unit 202 generates second learning data used for learning of the second learning model based on raw data (such as data measured by various sensors provided in the stationary power supply system) collected from the stationary power supply system (preferably, a large number of systems incorporating batteries of the same type). The learning unit 203 generates a second trained model by performing machine learning on the second learning model.

The second server 20 is connected to a transmission/reception unit 29 that transmits and receives information to and from external devices (such as the first server 10 and the device controller 40). The second server 20 collects raw data from the device controller 40. In addition, the second server 20 provides the second trained model to the device controller 40.

The second server 20 corresponds to the "machine learning device" according to the present disclosure. The learning unit 203 corresponds to the "learning unit" according to the present disclosure. The second trained model corresponds to the "trained model" according to the present disclosure.

The vehicle ECU 30 controls a vehicle (not shown) on which the battery 51 that is used in the primary use is mounted. The vehicle ECU 30 includes a raw data collection unit 301 and a model storage unit 302.

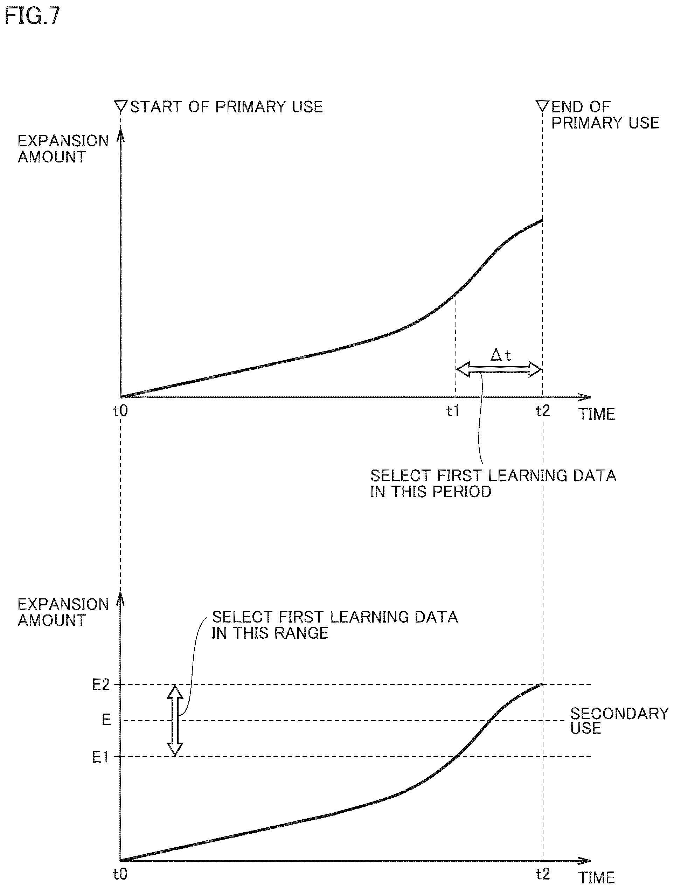

The raw data collection unit 301 collects first raw data related to the battery 51 during primary use. The first raw data includes a use history of the battery 51 during primary use. For example, the first raw data may include a temperature history (such as a temporal change or a frequency distribution of the temperature) of the battery 51 during primary use (both during charging and discharging and during a pause). The first raw data may include a charging and discharging history (such as a temporal change or a frequency distribution of a voltage and/or a current) of the battery 51 during primary use (during charging and discharging). The first raw data may include the number of times the battery 51 has been charged and discharged during primary use, and may include a start time and/or an end time of charging/discharging of the battery 51 during primary use. The first raw data may include an amount of change in shape (expansion amount or the like) of the battery 51 (see Fig. 7 described later). The first raw data may include a travel distance of the vehicle.

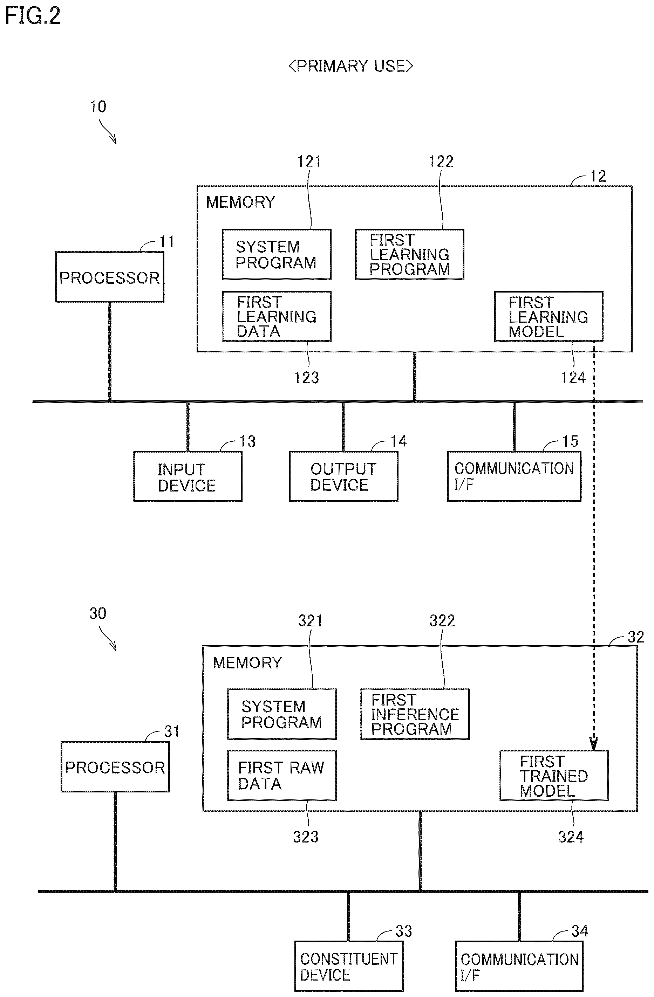

The model storage unit 302 stores a first trained model 324 (see Fig. 2) for estimating various battery parameters related to the battery 51 during primary use. The battery parameter is a parameter indicating a state of the battery 51, and typically includes a state of charge (SOC) of the battery 51. The battery parameters may include a state of health (SOH) (full charge capacity, capacity retention ratio, etc.) of the battery 51. However, the battery parameters are not limited to these, and may include a self-discharge amount of the battery 51, and may include a value indicating an abnormality of the battery 51 (such as excessive expansion of the electrode assembly, short circuit in the electrode assembly, or leakage of an electrolyte solution). When the processing target in the inference phase is not the SOC, the first raw data may include the SOC of the battery 51.

The vehicle includes a data communication module (DCM) 39. The vehicle ECU 30 transmits the first raw data collected from the vehicle to the first server 10. The vehicle ECU 30 acquires the first trained model generated by the first server 10 from the first server 10.

The device controller 40 controls a stationary power supply system (not shown) in which the battery 52 for secondary use (reuse of the battery 51 for primary use) is disposed. The device controller 40 includes a raw data collection unit 401 and a model storage unit 402.

The raw data collection unit 401 acquires second raw data regarding the battery 52 during secondary use. Similarly to the first raw data, the second raw data includes a use history of the battery 52 during secondary use. The second raw data may include, for example, a temperature history, a charging and discharging history, the number of times the battery has been charged and discharged, and a start time and/or an end time of charging/discharging of the battery 52 during secondary use. The second raw data may include an amount of change in shape of the battery 52. When the processing target in the inference phase is not the SOC, the second raw data may include the SOC of the battery 52.

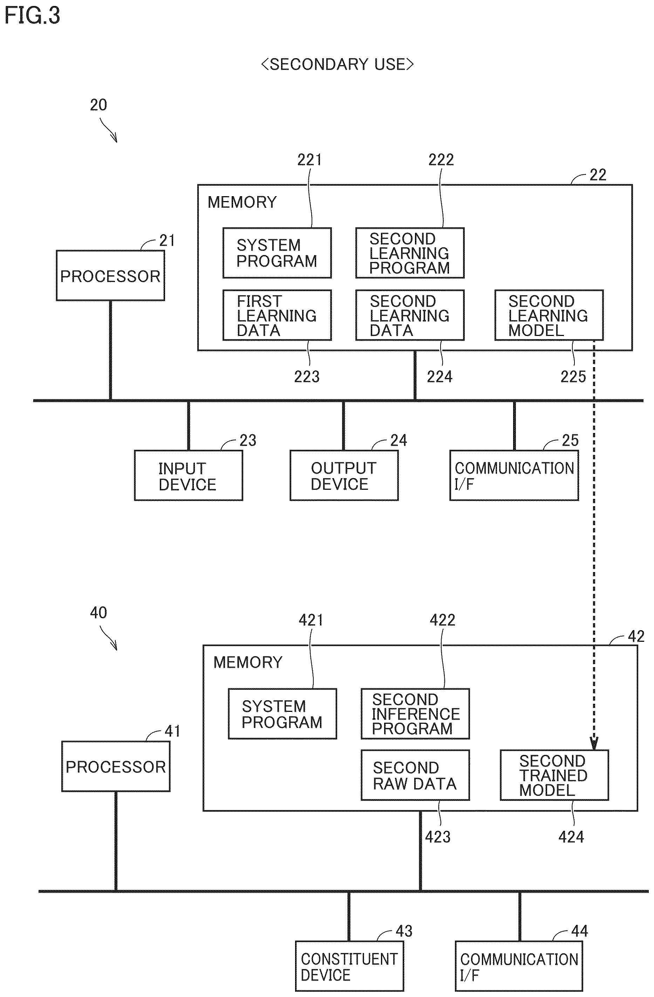

The model storage unit 402 stores a second trained model 424 (see Fig. 3) used for estimating various battery parameters related to the battery 52 during secondary use. The battery parameters typically include the SOC of battery 52, like the battery parameters during primary use. The battery parameters may include an SOH of the battery 52, may include a self-discharge amount of the battery 52, or may include a value indicating an abnormality of the battery 52.

### <Configuration of Each Device>

Fig. 2 is a block diagram showing an example of the configuration of the first server 10 and the vehicle ECU 30, each relating to primary use of a battery. The first server 10 includes, for example, a processor 11, a memory 12, an input device 13, an output device 14, and a communication interface 15.

The processor 11 is an arithmetic processing device such as central processing unit (CPU) or micro processing unit (MPU). The processor 11 implements various arithmetic processing by reading a program, a parameter, a map, a first learning model 124 (described later), and the like stored in the memory 12 and deploying them in the memory 12. Note that, in the present specification, the "processor" is not limited to a processor in a narrow sense that executes processing by a stored program method, and may include a hardwired circuit such as ASIC (Application Specific Integrated Circuit), FPGA (Field-Programmable Gate Array). As such, the term "processor" may also be read to refer to processing circuitry in which processing is predefined by computer readable code and/or hardwired circuitry.

The memory 12 includes, for example, a volatile storage device such as DRAM (Dynamic Random Access Memory) or SRAM (Static Random Access Memory), and a nonvolatile storage device such as HDD (Hard Disk Drive), SSD (Solid State Drive), or flash memory. The memory 12 stores a system program 121 including an OS (Operating System), a learning program 122 for training (in this example, supervised machine learning) the first learning model 124, first learning data 123 which is a group of learning data used for training the first learning model 124, and the first learning model 124 trained using the first learning data 123.

The input device 13 is a keyboard, a mouse, a touch panel, an operation button, or the like, and is configured to receive an operation by a user (a person in charge of a manufacturer of the vehicle, or the like) of the first server 10. The output device 14 is a monitor, a printer, or the like, and is configured to output the progress and the result of the arithmetic processing by the processor 11. The communication interface 15 is configured to transmit and receive information to and from the outside via the transmission/reception unit 19 (see Fig. 1).

The vehicle ECU 30 includes, for example, a processor 31, a memory 32, a constituent device 33, and a communication interface 34.

The processor 31 is an arithmetic processing device similar to the processor 11. Like the memory 12, the memory 32 includes a volatile storage device and a nonvolatile storage device. The processor 31 implements various arithmetic processing by reading a program or the like stored in the memory 32 and deploying the program or the like in the memory 32. The memory 32 stores a system program 321, a first inference program 322 for executing inference (estimation of battery parameters) using a first trained model 324, first raw data 323 collected from vehicles, and the first trained model 324 (first learning model 124 for which training has been completed) acquired from the first server 10.

The constituent device 33 is a device to be variously controlled using the battery 51, and includes, for example, a PCU (Power Control Unit) used for traveling of the vehicle, and a charging device (converter and/or inverter) (both not shown) for charging the battery 51. The communication interface 34 is configured to transmit and receive information to and from the outside via the DCM 39 (see Fig. 1).

Fig. 3 is a block diagram showing an example of the configuration of the second server 20 and the device controller 40 each relating to secondary use of a battery. The second server 20 includes, for example, a processor 21, a memory 22, an input device 23, an output device 24, and a communication interface 25.

The processor 21 is an arithmetic processing device similar to the processors 11 and 31. Like the memories 12 and 32, the memory 22 includes a volatile storage device and a nonvolatile storage device. The processor 21 implements various arithmetic processing by reading a program or the like stored in the memory 22 and deploying the program or the like in the memory 22. The memory 22 stores a system program 221, a second learning program 222 for training (in this example, supervised machine learning) the second learning model 125, first learning data 223 and second learning data 224 which are a group of learning data used for training the second learning model 225, and a second learning model 225 trained using the first learning data 223 and the second learning data 224.

The input device 23, the output device 24, and the communication interface 25 are equivalent to the corresponding devices in the first server 10, and thus description thereof will not be repeated.

The device controller 40 includes, for example, a processor 41, a memory 42, a constituent device 43, and a communication interface 44.

The processor 41 is an arithmetic processing device similar to the processors 11, 21, and 31. Like the memories 12, 22, and 32, the memory 42 includes a volatile storage device and a nonvolatile storage device. The processor 31 implements various arithmetic processing by reading a program or the like stored in the memory 32 and deploying the program or the like in the memory 42. The memory 32 stores a system program 421, a second inference program 422 for executing inference (estimation of battery parameters) using a second trained model 424, second raw data 423 collected from the stationary power supply system, and the second trained model 424 acquired from the second server 20. The second trained model 424 is the second learning model 225 for which training is completed by the second server 20. However, the device controller 40 may perform part of or all of the training of the second learning model 225 (continuation of training by the second server 20) using the second learning program.

The constituent device 43 is a device to be variously controlled using the battery 52, and includes, for example, a converter and/or an inverter (not shown) for charging and discharging the battery 52. The constituent device 43 may include a display (not shown) that displays information to a user (e.g., an administrator) of the stationary power supply system. The communication interface 44 is configured to transmit and receive information to and from the outside via the transmission/reception unit 49 (see Fig. 1).

### <Machine Learning Model>

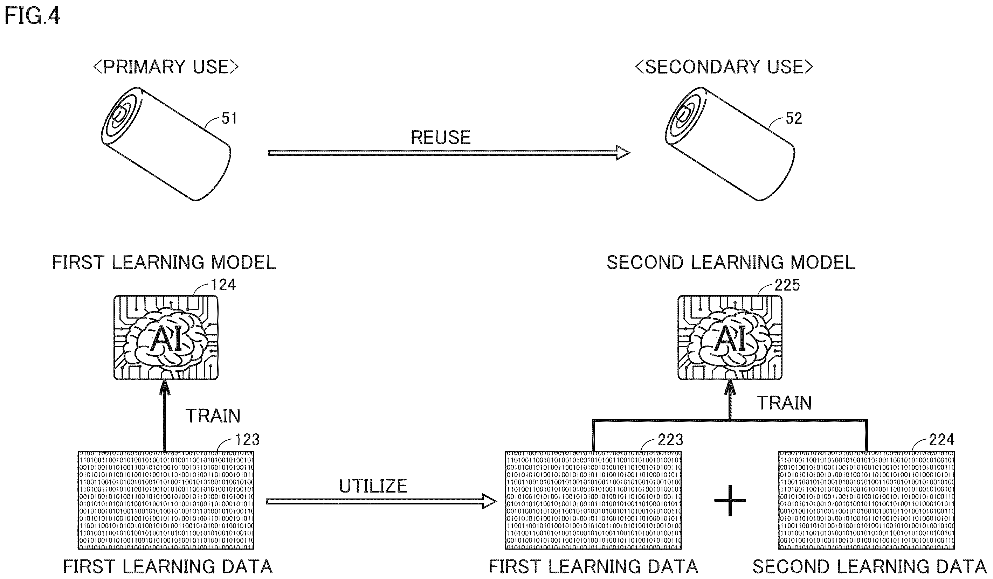

Fig. 4 is a conceptual diagram for explaining the machine learning models (the first learning model 124 and the second learning model 225) according to the embodiment of the present disclosure. With reference to Fig. 1, Fig. 3, and Fig. 4, in the present embodiment, in addition to the first learning data 123 based on the first raw data collected from the vehicle during primary use of the battery 51 being used for training of the first learning model 124, part or all of the first learning data 123 is utilized (used or reused) for training of the second learning model 225. That is, part or all of the first learning data 123 is provided from the first server 10 to the second server 20 as the first learning data 223, and the second server 20 trains the second learning model 225 using both the first learning data 223 and the second learning data 224.

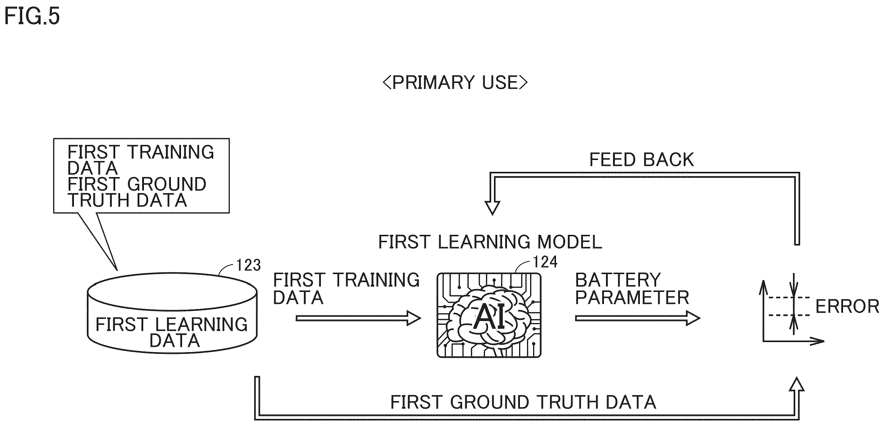

Fig. 5 is a diagram for explaining generation of the first learning model 124 related to primary use of the battery 51. Referring to Figs. 1, 2, and 5, the first learning model 124 is, for example, a neural network model. Techniques such as convolutional neural network (CNN), residual neural network (ResNet), generative adversarial network (GAN), stacked autoencoder, and transformer may be used to generate the first learning model 124.

The first server 10 (learning unit 102) trains the first learning model 124 using the first learning data 123. More specifically, in this example, the first learning data 123 includes first training data and first ground truth data (ground truth label). The first server 10 inputs the first training data to the first learning model 124, and acquires an inference result (estimation result of the battery parameter) from the first learning model 124. The first server 10 trains the first learning model 124 by feeding back an error between the first ground truth data and the estimation result of the battery parameter.

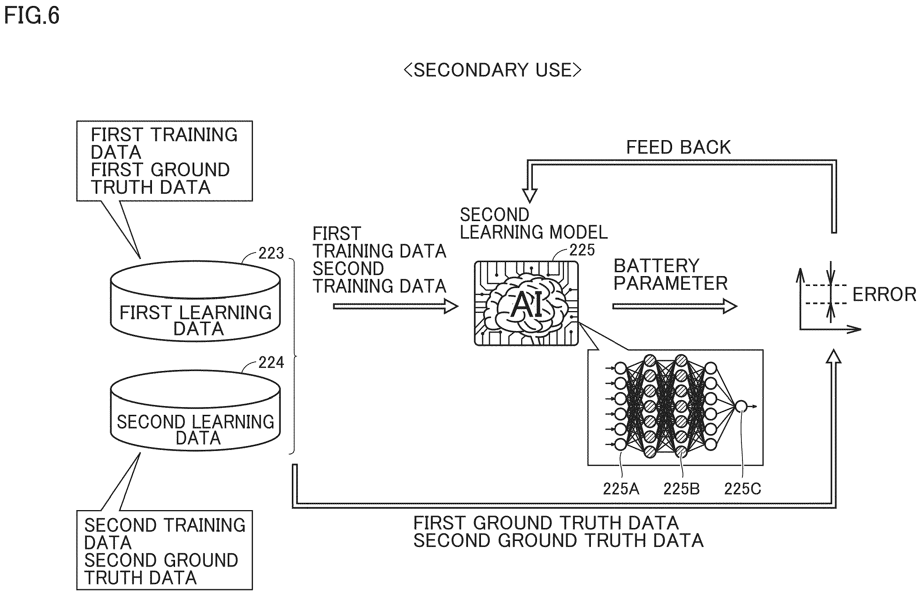

Fig. 6 is a diagram for explaining generation of the second learning model 225 related to secondary use of the battery 52. Referring to Figs. 1, 3, and 6, the second learning model 225 is, for example, a neural network model, similarly to the first learning model 124. For the generation of the second learning model 225, techniques similar to those for the generation of the first learning model 124 may be used.

The second server 20 (learning data acquisition unit 201) acquires part or all of the first learning data 123 (the first raw data may be included) from the first server 10, and stores the acquired data as the first learning data 223. The second server 20 (learning data generation unit 202) generates the second learning data 224 (which may be the second raw data as it is) based on the second raw data collected during secondary use of the battery 52.

The second server 20 (learning unit 203) trains the second learning model 225 using both the first learning data 223 and the second learning data 224. More specifically, in this example, the first learning data 223 includes first training data and first ground truth data. The second learning data 224 includes second training data and second ground truth data. The second server 20 inputs the first training data and the second training data to the second learning model 225, and acquires an inference result (estimation result of the battery parameter) from the second learning model 225. The first server 10 trains the second learning model 225 by feeding back an error between the first ground truth data and the estimation result of the battery parameter and/or an error between the second ground truth data and the estimation result of the battery parameter.

The trained second learning model 225 (i.e., the second trained model 424) includes an input layer 225A that receives the first training data and the second training data, one or more intermediate layers (hidden layers) 225B, and an output layer 225C that outputs an estimation result of the battery parameter. The one or more intermediate layers 225B are trained based on the first learning data 223 and the second learning data 224. The one or more intermediate layers 225B are an example of "model architecture" in accordance with the present disclosure.

Fig. 7 is a diagram for explaining first learning data used for training the second learning model 225. The horizontal axis represents the elapsed time from the start (t0) of the primary use of the battery 51. The vertical axis represents the expansion amount of the battery 51 in this example. The vertical axis may be other data (data related to temperature, voltage, current, or the like) that can be used as the first learning data.

When providing the first learning data 123 to the second server 20, the first server 10 preferably selects, from the first learning data 123, data from a time point (t1) preceding an end time point (t2) of the primary use by a predetermined period of time Δt, to the end time point (t2) of the primary use. The second server 20 (learning unit 203) performs training on the second learning model 225 as described with reference to Fig. 6 using the data selected by the first server 10.

Data over the entire period from the start time point (t0) to the end time point (t2) of the primary use of the battery 51 may be used as the first learning data 223. However, the state of the battery 51 in the period from the time point (t1) preceding the end time point (t2) of the primary use by the predetermined period of time Δt to the end time point (t2) of the primary use is closer to the state of the battery 52 during the secondary use than before. In the present embodiment, the accuracy of inference (estimation of battery parameters) by the second trained model 424 can be improved by training the second learning model 225 by selectively using data during the period as the first learning data 223.

In addition, it is preferable that the first server 10 selects, as the first learning data 123, data acquired under a condition that an amount of difference between a state of the battery during primary use and a state of the battery during secondary use is less than a predetermined amount. In this example, when the expansion amount of the battery 52 during secondary use is E, the first server 10 selects data acquired under a condition that the expansion amount of the battery 51 during primary use is close to E (specifically, under a condition that the expansion amount is within a range from E1 to E2) from the first learning data 123. The second server 20 (learning unit 203) performs training of the second learning model 225 using the data selected by the first server 10.

The accuracy of inference (estimation of battery parameters) by the second trained model 424 can be improved by training the second learning model 225 by selectively using data acquired under a condition that an amount of difference between a state of the battery during primary use and a state of the battery during secondary use is less than a predetermined amount.

The selection of the first learning data 123 used for training the second learning model 225 may be performed by the second server 20. That is, the second server 20 (learning data acquisition unit 201) may select a part of the data from the first learning data 223 acquired from the first server 10 based on the acquisition period of the data or the state difference amount of the battery.

However, some data may not be selected from the first learning data 123. That is, all of the first learning data 123 may be used for training of the second learning model 225.

### <Process Flow>

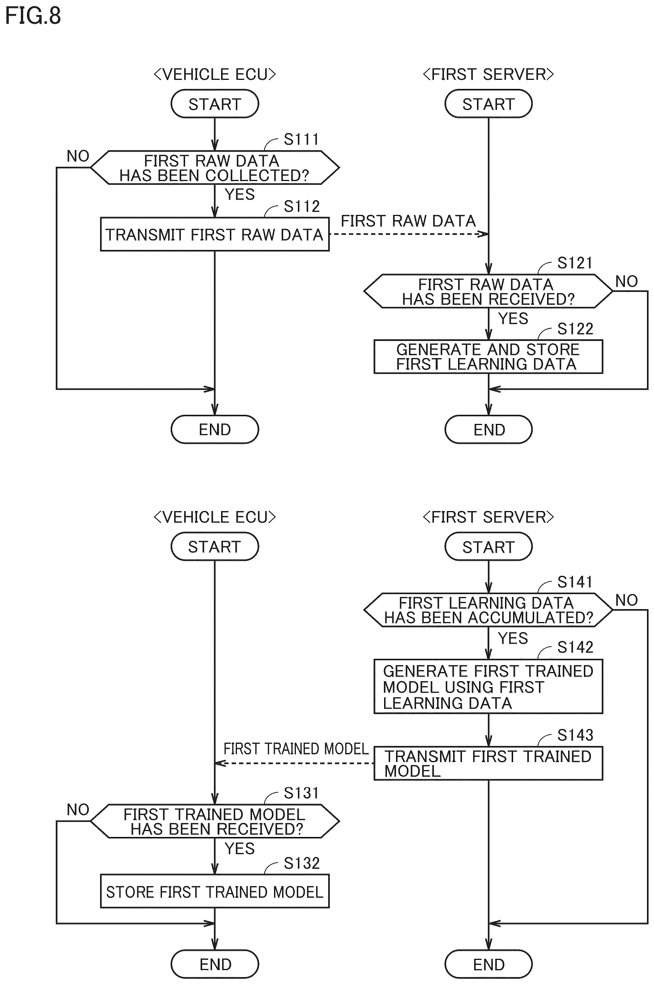

Fig. 8 is a flowchart illustrating an example of a processing procedure related to generation of the first learning data 123 and generation of the first trained model 324 during primary use of the battery 51. The process shown in this flowchart is executed when a predetermined condition is satisfied (for example, every predetermined cycle). The same applies to other flowcharts described later. Each step is typically realized by software processing by the vehicle ECU 30 (processor 31) or the first server 10 (processor 11), but may be realized by hardware (electrical circuit). Hereinafter, the step is abbreviated as S.

Referring to Figs. 2, 5, and 8, in S111, vehicle ECU 30 determines whether or not the first raw data indicating a use history of the battery 51 during primary use has been collected. When the first raw data has been collected (YES in S111), the vehicle ECU 30 transmits the first raw data to the first server 10 (S112). The first server 10 determines whether or not the first raw data has been acquired from the vehicle ECU 30 (S121). When the first raw data has been acquired (YES in S121), the first server 10 generates the first learning data 123 from the first raw data and stores the generated first learning data 123 in the memory 12 (S122).

In S141, the first server 10 determines whether or not a predetermined amount of the first learning data 123 has been accumulated in the memory 12. When the predetermined amount of the first learning data 123 has been accumulated (YES in S141), the first server 10 performs training of the first learning model 124 using the first learning data 123. Thus, the first trained model is generated (S142). The first server 10 transmits the first trained model to the vehicle ECU 30 in accordance with, for example, a request from the vehicle ECU 30 (S143). The vehicle ECU 30 determines whether or not the first trained model has been received from the first server 10 (S131). When the first trained model has been received (YES in S131), the vehicle ECU 30 stores the received model in the memory 32 as the first trained model 324 (S132).

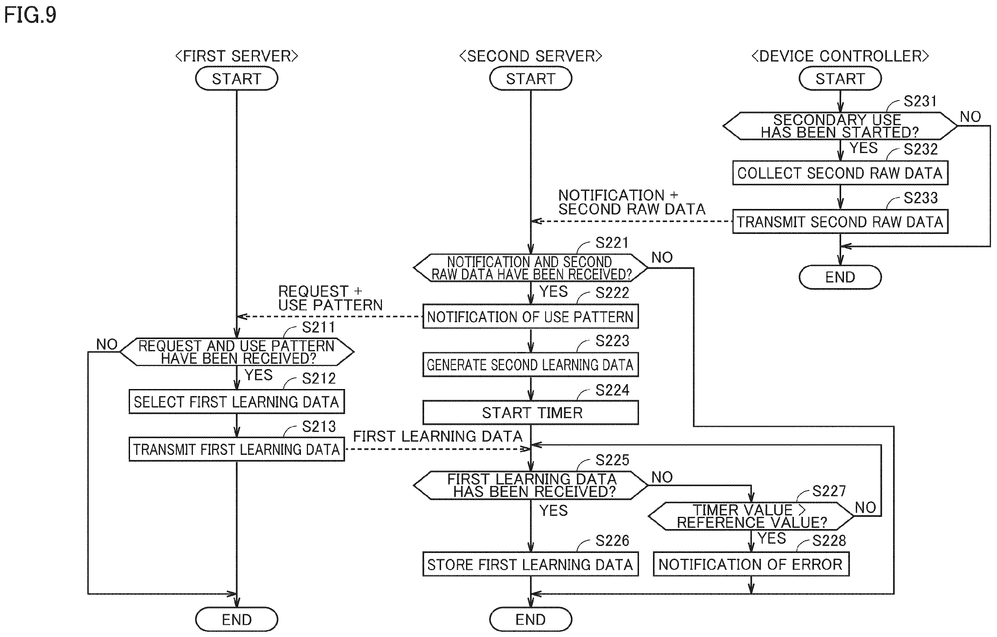

Fig. 9 is a flowchart illustrating an example of a processing procedure related to acquisition of the first learning data 223 during secondary use of the battery. Each step is typically realized by software processing by the first server 10 (processor 11), the second server 20 (processor 21), or the device controller 40 (processor 41), but may be realized by hardware (electrical circuit).

Referring to Figs. 1 to 3 and 9, in S231, the device controller 40 determines whether or not secondary use of the battery 52 has been started. When the secondary use of the battery 52 has been started (YES in S231), the device controller 40 collects the second raw data indicating a use history of the battery 52 (S232). The device controller 40 notifies the second server 20 of the start of secondary use of the battery 52, and transmits the second raw data to the second server 20 (S233). After that, the device controller 40 may continuously (for example, periodically) collect the second raw data and transmit the second raw data to the second server 20.

In S221, the second server 20 determines whether or not a notification of the start of secondary use of the battery 52 and the second raw data have been received from the device controller 40. When these have been received (YES in S221), the second server 20 requests the first server 10 to transmit the first learning data (the first raw data may be included) to the second server 20. In addition, the second server 20 estimates the manner of use of the battery 52 based on the second raw data, and transmits data indicating the estimated manner of use to the first server 10 (S222). In this example, the data is hereinafter referred to as a "use pattern". A plurality of use patterns having different battery use loads, state of health, and the like are prepared in advance. The second server 20 selects, from among the plurality of use patterns, a use pattern for the use load, the state of health, and the like of the battery 52 during secondary use. In addition, the second server 20 generates the second learning data 224 based on the second raw data (S223). Then, the second server 20 starts a timer for measuring the response time from the first server 10 (S224).

In S211, the first server 10 determines whether or not the request to transmit the first learning data and the use pattern of the battery 52 have been received from the second server 20. When these have been received (YES in S211), the first server 10 selects the first learning data according to the use pattern of the battery 52 from the first learning data 123 stored in the first server 10 (S212). Since the selection method has been described in detail with reference to Fig. 7, the description thereof will not be repeated here. Then, the first server 10 transmits the selected first learning data to the second server 20 (S213).

In S225, the second server 20 determines whether or not the first learning data has been received from the first server 10. When the first learning data has been received (YES in S225), the second server 20 stores the received first learning data 223 in the memory 12 (S226). On the other hand, when the first learning data 223 has not been received (NO in S225), the second server 20 determines whether the timer value exceeds the reference value (S227). The second server 20 returns the process to S225 and waits until the timer value exceeds the reference value (NO in S227), and when the timer value exceeds the reference value (YES in S227), notifies the user of the second server 20 (a person in charge of the manufacturer of the vehicle, an administrator of the stationary power supply system, or the like) of an error that the first learning data 223 has not been received normally (S228).

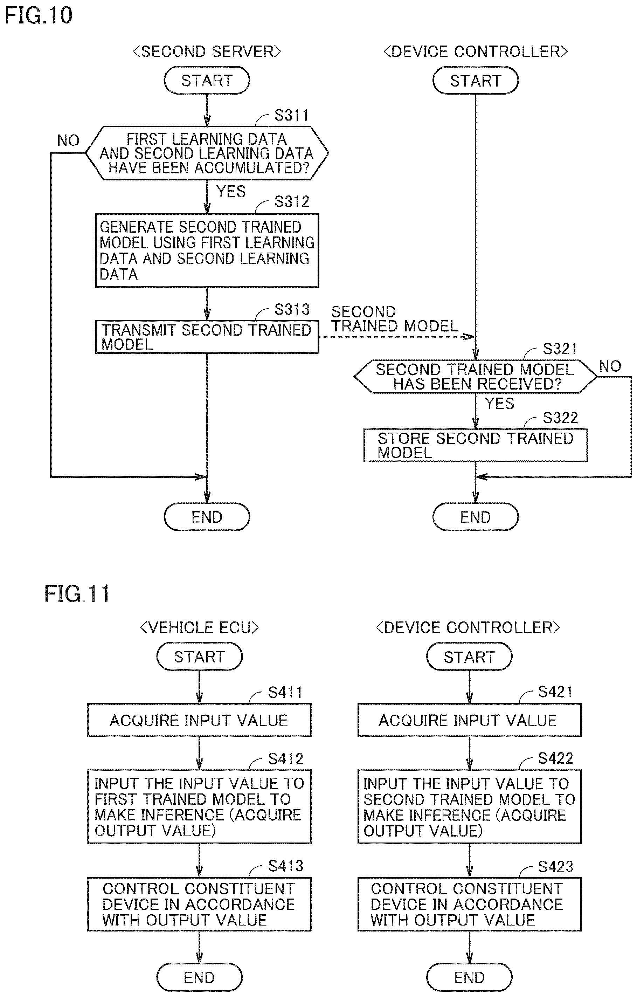

Fig. 10 is a flowchart illustrating an example of a processing procedure related to generation of the second trained model 424 during secondary use of the battery 52. Each step is typically realized by software processing by the second server 20 (processor 21) or the device controller 40 (processor 41), but may be realized by hardware (electrical circuit).

Referring to Figs. 3, 6, and 10, in S311, the second server 20 determines whether or not a predetermined amount of learning data (first learning data 223 and second learning data 224) has been accumulated in the memory 22. The predetermined amount of learning data is a sufficient amount of learning data for the learning process of the second learning model 225. When the predetermined amount of the first learning data 223 and the second learning data 224 have been accumulated (YES in S311), the second server 20 performs training of the second learning model 225 using both the first learning data 223 and the second learning data 224. As a result, a second trained model is generated (S312). The second server 20 transmits the second trained model to the device controller 40 in accordance with, for example, a request from the device controller 40 (S313). The device controller 40 determines whether or not the second trained model has been received from the second server 20 (S321). When the second trained model has been received (YES in S321), the device controller 40 stores the received model in the memory 42 as the second trained model 424 (S322).

Fig. 11 is a flowchart illustrating an example of a processing procedure of inference by the first trained model 324 or the second trained model 424. Each step is typically realized by software processing by the vehicle ECU 30 (processor 31) or the device controller 40 (processor 41), but may be realized by hardware (electrical circuit).

Referring to Figs. 2, 3, and 11, in S411, the vehicle ECU 30 acquires an input value to be input to the first trained model 324. The input value corresponds to the first raw data. The input value includes, for example, at least one of a temperature, a voltage, and a current of the battery 51 during primary use. The input value may include an amount of change in shape of the battery 51 during primary use. The vehicle ECU 30 inputs the input value to the first trained model 324 and acquires the output value from the first trained model 324 (S412). The output value is an SOC, an SOH, a self-discharge amount, a value indicating an abnormality, or the like of the battery 51. The vehicle ECU 30 controls the constituent device 33 of the vehicle in accordance with the acquired output value (S413). As one specific example, the vehicle ECU 30 controls the PCU, the charging device, and the like of the vehicle so as to suppress the charge/discharge power of the battery 51 as compared with the previous case. The vehicle ECU 30 may control a display (a monitor of a navigation system, an instrument panel, or the like) to display the acquired output value.

In S421, the device controller 40 acquires an input value to be input to the second trained model 424. This input value corresponds to the second raw data. The input value includes, for example, at least one of a temperature, a voltage, and a current of the battery 52 during secondary use. The input value may include an amount of change in shape of the battery 52 during secondary use. The device controller 40 inputs an input value to the second trained model 424, and acquires an output value from the second trained model 424 (S422). The output value is an SOC, an SOH, a self-discharge amount, a value indicating an abnormality, or the like of the battery 52. The device controller 40 controls the constituent devices 43 of the stationary power supply system according to the acquired output value (S423). As one specific example, the device controller 40 controls the converter and/or the inverter to suppress the charge/discharge power of the battery 52 as compared to the previous case. The device controller 40 may control the display to display the acquired output values.

### <Conclusion>

As described above, according to the present embodiment, the first learning data based on the first raw data acquired during primary use of the battery 51 is used for training (learning) of the second learning model 225 used during secondary use of the battery 52. As a result, even in the case where or at the time when the amount of learning data (second learning data 224) necessary for training the second learning model 225 cannot be prepared during secondary use of the battery 52, a sufficient amount of learning data (first learning data 223 and second learning data 224) can be ensured. Therefore, according to the present embodiment, it is possible to suitably generate the second trained model 424 used for secondary use of the battery 52.

### [Clauses]

It will be understood by those skilled in the art that the exemplary embodiments described above are specific examples of the following aspects.

### <Clause 1>

A machine learning method performed by a computer includes:
acquiring first learning data indicating a use history of a battery during primary use of the battery, and having been used for training a first learning model configured to estimate, during the primary use, a battery parameter indicating a state of the battery;
generating second learning data indicating a use history of the battery during secondary use of the battery; and
training a second learning model by inputting the first learning data and the second learning data to the second learning model for estimating the battery parameter during the secondary use.

### <Clause 2>

The machine learning method according to Clause 1, further including selecting, from the first learning data, data acquired from a time point preceding an end time point of the primary use by a predetermined period of time, to the end time point of the primary use, and using the selected data for training the second learning model.

### <Clause 3>

The machine learning method according to Clause 1 or 2, further including selecting, from the first learning data, data acquired under a condition that an amount of difference between a state of the battery during the primary use and a state of the battery during the secondary use is less than a predetermined amount, and using the selected data for training the second learning model.

### <Clause 4>

The machine learning method according to any one of Clauses 1 to 3, wherein
the training includes:
inputting the first learning data and the second learning data to the second learning model and acquiring a result of estimation of the battery parameter from the second learning model; and
training the second learning model based on an error between ground truth data of each of the first learning data and the second learning data and the result of estimation of the battery parameter.

### <Clause 5>

The machine learning method according to any one of Clauses 1 to 4, wherein the battery parameter includes a value indicating at least one of a state of charge, a state of health, a self-discharge amount, and an abnormality of the battery.

### <Clause 6>

The machine learning method according to any one of Clauses 1 to 5, wherein
the first learning data includes data indicating at least one of a temperature history, a charging and discharging history, the number of times charging and discharging are performed, a start time or an end time of charging and discharging, and an amount of change in shape, of the battery during the primary use, and
the second learning data includes data indicating at least one of a temperature history, a charging and discharging history, the number of times charging and discharging are performed, a start time or an end time of charging and discharging, and an amount of change in shape, of the battery during the secondary use.

Although the present disclosure has been described and illustrated in detail, it is clearly understood that the same is by way of illustration and example only and is not to be taken by way of limitation, the scope of the present disclosure being interpreted by the terms of the appended claims.

## Claims

1. A machine learning method performed by a computer (20), the machine learning method comprising:
acquiring first learning data, the first learning data indicating a use history of a battery (51, 52) during primary use of the battery (51, 52), and having been used for training a first learning model (124) configured to estimate, during the primary use, a battery parameter indicating a state of the battery (51, 52);
generating second learning data indicating a use history of the battery (51, 52) during secondary use of the battery; and
training a second learning model (225) by inputting the first learning data and the second learning data to the second learning model (225) for estimating the battery parameter during the secondary use.

2. The machine learning method according to claim 1, further comprising selecting, from the first learning data, data acquired from a time point preceding an end time point of the primary use by a predetermined period of time, to the end time point, and using the selected data for training the second learning model (225).

3. The machine learning method according to claim 1 or 2, further comprising selecting, from the first learning data, data acquired under a condition that an amount of difference between a state of the battery (51, 52) during the primary use and a state of the battery during the secondary use is less than a predetermined amount, and using the selected data for training the second learning model (225).

4. The machine learning method according to any one of claims 1 to 3, wherein
the training includes:
inputting the first learning data and the second learning data to the second learning model (225) and acquiring a result of estimation of the battery parameter from the second learning model (225); and
training the second learning model (225) based on an error between ground truth data of each of the first learning data and the second learning data and the result of estimation of the battery parameter.

5. The machine learning method according to any one of claims 1 to 4, wherein the battery parameter includes a value indicating at least one of a state of charge, a state of health, a self-discharge amount, and an abnormality of the battery (51, 52).

6. The machine learning method according to any one of claims 1 to 5, wherein
the first learning data includes data indicating at least one of a temperature history, a charging and discharging history, the number of times charging and discharging are performed, a start time or an end time of charging and discharging, and an amount of change in shape, of the battery (51, 52) during the primary use, and
the second learning data includes data indicating at least one of a temperature history, a charging and discharging history, the number of times charging and discharging are performed, a start time or an end time of charging and discharging, and an amount of change in shape, of the battery (51, 52) during the secondary use.

7. A machine learning device (20) comprising:
a first data acquisition unit (29) that acquires first learning data, the first learning data indicating a use history of a battery (51, 52) during primary use of the battery (51, 52), and having been used for training a first learning model (124) configured to estimate, during the primary use, a battery parameter indicating a state of the battery (51, 52);
a second data acquisition unit (201) that acquires second learning data indicating a use history of the battery (51, 52) during secondary use of the battery; and
a learning unit (203) that trains a second learning model (225) by inputting the first learning data and the second learning data to the second learning model (225) for estimating the battery parameter during the secondary use.

8. A trained model (424) that causes a computer to perform a process of outputting a result of estimation of a battery parameter indicating a state of a battery (51, 52) during secondary use of the battery, in response to receiving input data indicating a use history of the battery (51, 52) during the secondary use of the battery,
the trained model comprising a model architecture (225B) trained based on first learning data and second learning data, the first learning data indicating a use history of the battery (51, 52) during primary use of the battery, and having been used for training a first learning model (124) configured to estimate the battery parameter during the primary use, and the second learning data indicating the use history during the secondary use.
